# EUROPÄISCHE PATENTSCHRIFT

(11) **EP 1 002 238 B1**
(45) Veröffentlichungstag und Bekanntmachung des Hinweises auf die Patenterteilung: **23.10.2002**
(21) Anmeldenummer: 98931819.1
(22) Anmeldetag: 20.07.1998
(51) Int. Cl.: G01R 31/01, H01C 17/00

(54) **MESS- UND SORTIERANLAGEN ZUM MESSEN UND SORTIEREN VON WIDERSTANDSKÖRPERN SOWIE EIN VERFAHREN**
INSTRUMENT FOR MEASURING AND SORTING RESISTORS AND METHOD THEREFOR
INSTALLATION POUR MESURER ET CLASSER DES RESISTANCES, ET PROCEDE CORRESPONDANT

(30) Priorität: 22.07.1997 AT 124197
(43) Veröffentlichungstag der Anmeldung: 24.05.2000
(73) Patentinhaber: M & R Automation GmbH, 8074 Grambach (AT)
(72) Erfinder: Maierhofer, Anton, A-8055 Neuseiersberg (AT); Maitz, Gerhard, A-8055 Graz (AT); Ritter, Herbert, A-8081 Heiligenkreuz Am Waasen (AT)
(74) Vertreter: Secklehner, Günter, Dr.
(86) Internationale Anmeldenummer: AT9800175
(87) Internationale Veröffentlichungsnummer: WO99005535

(56) Entgegenhaltungen:
- DE-A- 1 541 885
- PATENT ABSTRACTS OF JAPAN vol. 017, no. 640 (E-1465), 26. November 1993 -& JP 05 206232 A (HITACHI LTD), 13. August 1993
- PATENT ABSTRACTS OF JAPAN vol. 015, no. 344 (P-1245), 30. August 1991 -& JP 03 130675 A (NEC KYUSHU LTD), 4. Juni 1991

## Beschreibung

Die Erfindung betrifft eine Meß- und Sortieranlage zum Messen und Sortieren von Widerstandskörpern, wie im Oberbegriff des Anspruches 1 und ein Verfahren wie im Oberbegriff des Anspruches 20 beschrieben.

Es sind bereits Meß- und Sortieranlagen bekannt, bei dem ein Widerstandskörper über eine Zufuhr- und Transportvorrichtung an eine Meßstation transportiert wird. Die Meßstation besteht aus einer Aufnahmevorrichtung zum Kontaktieren des Widerstandskörpers und einer Meßvorrichtung zum Ermitteln des Widerstandswertes des Widerstandskörpers. Damit der Widerstandskörper bei einer Nenntemperatur gemessen werden kann, erfolgt die Messung in einem klimatisierten Raum. Dazu wird der Raum auf eine vorgegebene Nenntemperatur temperiert. Nachteilig ist bei einer derartigen Meßund Sortieranlage, daß zur Messung des Widerstandswertes bei einer vorgegebenen Nenntemperatur ein hoher Aufwand zur Klimatisierung des Raumes entsteht, da äußere Einflüsse wie beispielsweise die Luftfeuchtigkeit kompensiert werden müssen.

In der JP 05-206232 ist eine Prüfvorrichtung für Halbleitervorrichtungen beschrieben, bei der ein IC auf einer Zufuhrvorrichtung angeordnet und über einen Bestückungsroboter einem scheibenförmigen Drehtisch zugeführt und über den Drehtisch in eine Temperierkammer eingebracht wird. In die Temperierkammer wird ein Medium eingebracht und für jeden Testlauf temperiert. Der IC, welcher transportiert wurde, wird über eine Vortemperierung erwärmt oder gekühlt, welche in der Temperierkammer angeordnet ist, während ein IC auf den Befehl zur Anordnung auf dem Kontaktsockel wartet. Die Temperatur des IC wird dann auf einen bestimmten Wert eingestellt und der IC wird in diesem Zustand überprüft. So kann die Einstelltemperatur mit hoher Präzision erreicht und es kann die Einstellzeit für die Umgebungsbedingungen am Anfangspunkt des Prüfvorganges reduziert werden.

Nachteilig ist dabei, daß in der Temperiervorrichtung keine Meßstation angeordnet ist, sodaß der zu messende IC aus dieser zur Durchführung der Messung an der Temperiervorrichtung ausgebracht werden muß, was die Messung nachteilig beeinflußt.

Aus der JP 03-130675 ist eine Prüfvorrichtung für IC's bekannt, welche einen mit Flüssigkeit befüllten Isoliertank aufweist. Ein zu prüfender IC wird auf einen Sockel einer Montageplatte aufgesetzt, welche in einer Rotationsbewegung in die temperierte Flüssigkeit eingetaucht wird. Im Flüssigkeitstank befindet sich ein Meßkabel mit hoher Genauigkeit, mit dem die Temperaturcharakteristik überwacht werden kann.

Nachteilig bei dieser Prüfvorrichtung ist, daß die Position des geprüften IC's nicht eruiert werden kann, weshalb die Sortierung der IC's nur schwerlich möglich ist.

Letztlich ist in der DE 15 41 885 A eine Vorrichtung zum Messen und Sortieren von elektrischen Bauelementen beschrieben, wobei eine Transportscheibe mit an ihrem Umfang angeordneten Kerben zur Aufnahme von Bauelementen vorgesehen ist und die Kontaktierung dieser Bauelemente über Kontaktschleifbahnen erfolgt, und eine Sortierklappe die Wege für "gute" und "schlechte" Bauelemente bestimmt.

Auch diese Vorrichtung weist keine zur Positionsermittlung vorgesehene Nullpunktvorrichtung auf, was sich nachteilig auf den Sortiervorgang auswirkt.

Die Aufgabe der Erfindung liegt darin, eine Meß- und Sortieranlage zum Messen und Klassifizieren von Widerstandskörper zu schaffen, bei dem ohne großen Aufwand die Messung des Widerstandskörpers bei Nenntemperatur erfolgt, und der Sortiervorgang vereinfacht wird.

Die Aufgabe der Erfindung wird durch die Maßnahmen im Kennzeichenteil des Anspruches 1 gelöst. Vorteilhaft ist hierbei, daß durch die zumindest teilweise Anordnung der Meßstation, insbesondere der Aufnahmevorrichtung in der Temperiervorrichtung, insbesondere im Medium eine exakte Messung des Widerstandskörpers bei Nenntemperatur ohne großen Aufwand erreicht wird. Ein weiterer nicht vorhersehbarer Vorteil liegt darin, daß durch die Verwendung einer Nullpunktvorrichtung zur Positionsermittlung der Widerstandskörper eine genaue Zuordnung des Meßergebnisses zum jeweiligen Widerstandskörper möglich ist, wodurch die Sortierung wesentlich erleichtert wird.

Von Vorteil sind auch die Ausführungen nach den Ansprüchen 2 bis 5, da dadurch in einfacher Form der Transport der Widerstandskörper zur Meßstation, insbesondere zur Aufnahmevorrichtung realisiert werden kann, wobei gleichzeitig mit dem Transport zur Meßstation der Widerstandskörper durch das Medium auf die Nenntemperatur erwärmt wird.

Möglich ist aber auch eine Ausbildung nach Anspruch 6, da dadurch mit einfachen Mitteln eine Messung des Widerstandskörpers bei Nenntemperatur durchgeführt werden kann, da die Regelung bzw. Steuerung der Nenntemperatur über ein flüssiges Medium erfolgt, sodaß äußere Einflüsse wie Luftfeuchtigkeit usw. nicht berücksichtigt werden müssen.

Eine vorteilhafte Weiterbildung ist im Anspruch 7 beschrieben, wodurch von der Steuervorrichtung jede Position der einzelnen Widerstandskörper in der Zufuhr- und Transportvorrichtung errechnet werden kann.

Es ist aber auch eine Ausbildung nach Anspruch 8 von Vorteil, da dadurch in einem Meßzyklus mehrere Widerstandskörper gemessen werden können, wodurch eine höhere Stückzahl von Widerstandskörpern in der selben Zeitdauer gemessen werden können.

Schließlich ist aber auch eine Ausbildung nach den Ansprüchen 9 bis 19 von Vorteil, da dadurch der Widerstandskörper mit unterschiedlichen Nenntemperaturen gemessen werden kann.

Die Aufgabe der Erfindung liegt aber auch darin, ein Verfahren zum Messen und Klassifizieren von Widerstandskörpern zu schaffen, bei dem ohne großem Aufwand die Messung eines Widerstandskörpers bei Nenntemperatur und exakte Zuordnung zu vorgegebenen Bereichen von Werten erfolgt.

Die Aufgabe der Erfindung wird durch die Maßnahmen im Kennzeichenteil des Anspruches 20 gelöst. Vorteilhaft ist hierbei, daß durch die zumindest teilweise Anordnung der Meßstation, insbesondere der Aufnahmevorrichtung in der Temperiervorrichtung, insbesondere im Medium eine exakte Messung des Widerstandskörpers bei Nenntemperatur ohne großem Aufwand erreicht wird und durch die laufende Überwachung der Position in der Meßvorrichtung eine exakte Zuordnung nach dem Meßvorgang erreicht wird.

Die Erfindung wird im nachfolgenden anhand der in den Zeichnungen dargestellten Ausführungsbeispiele näher erläutert.

Es zeigen:
- Fig. 1: eine erfindungsgemäße Meß- und Sortieranlage, in vereinfachter, schematischer Darstellung;
- Fig. 2: eine Temperiervorrichtung der erfindungsgemäßen Meß- und Sortieranlage, in vereinfachter, schematischer Darstellung und Seitenansicht, geschnitten;
- Fig. 3: eine Stirnansicht der Temperiervorrichtung der erfindungsgemäßen Meß- und Sortieranlage, geschnitten und in vereinfachter, schematischer Darstellung;
- Fig. 4: eine Ausführungsform der Temperiervorrichtung der erfindungsgemäßen Meß- und Sortieranlage, in vereinfachter, schematischer Darstellung und in Stirnansicht, geschnitten;
- Fig. 5: eine weitere Ausführungsform der Meß- und Sortieranlage, in vereinfachter, schematischer Darstellung.

Einführend sei festgehalten, daß in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale aus den gezeigten unterschiedlichen Ausführungsbeispielen für sich eigenständige, erfindungsgemäße Lösungen darstellen.

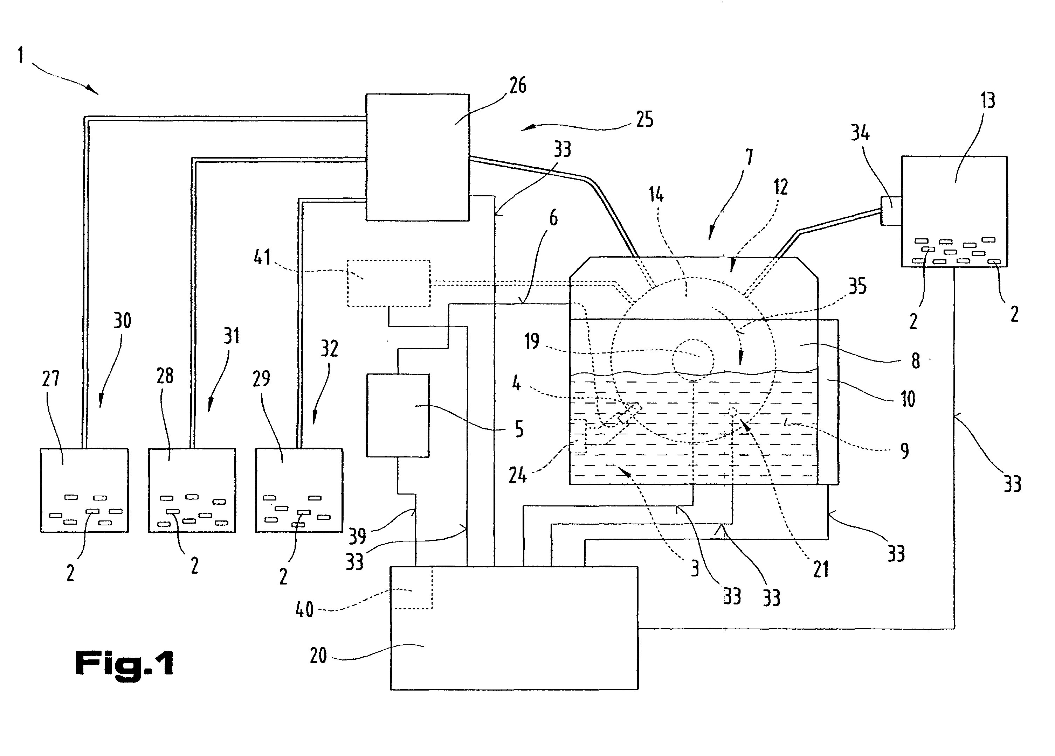

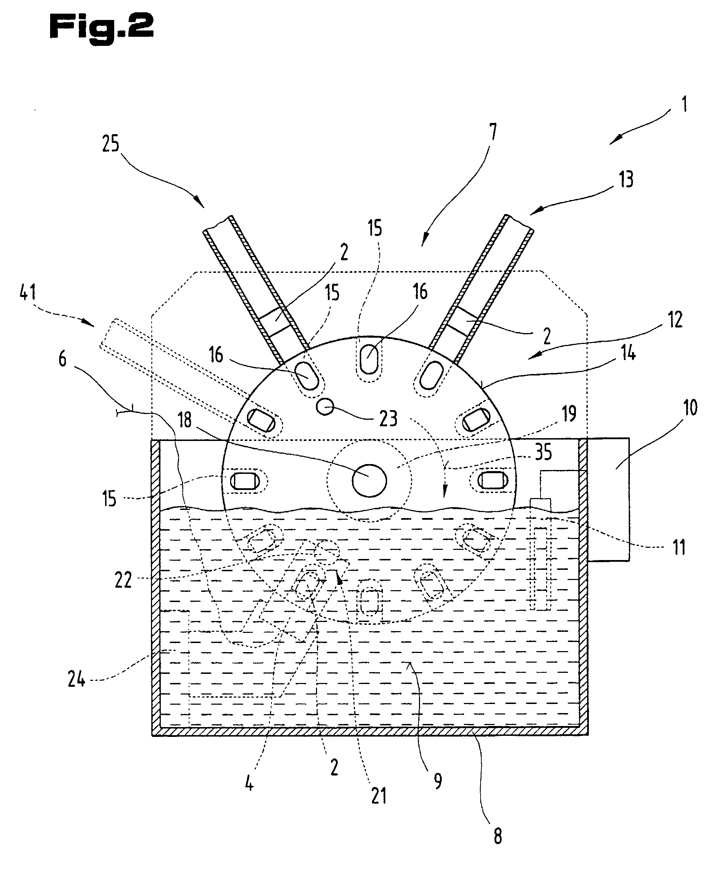

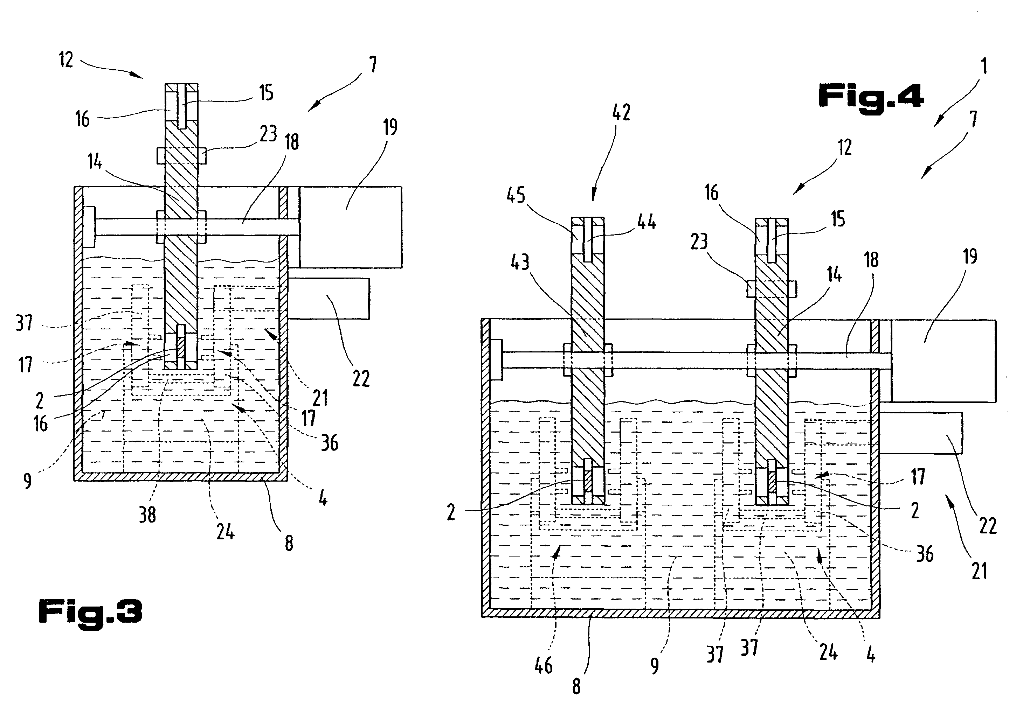

In den Fig. 1 bis 3 ist eine Meß- und Sortieranlage 1 zum Klassifizieren von Widerstandskörpern 2 entsprechend ihren Widerstandswerten gezeigt.

Die Meß- und Sortieranlage 1 weist eine Meßstation 3 zum Messen des Widerstandswertes des Widerstandskörpers 2 auf. Die Meßstation 3 wird durch eine Aufnahmevorrichtung 4 und eine Meßvorrichtung 5, die voneinander getrennt sein können, gebildet, wobei die Aufnahmevorrichtung 4 mit der Meßvorrichtung 5 über zumindest eine Leitung 6 verbunden ist.

Die Aufnahmevorrichtung 4 zum Kontaktieren des Widerstandskörpers 2 ist in einer Temperiervorrichtung 7 angeordnet.

Die Temperiervorrichtung 7 wird durch ein Aufnahmebecken 8, in dem ein flüssiges, nicht leitendes Medium 9 eingefüllt ist, gebildet. Dazu wird die Aufnahmevorrichtung 4 derart in der Temperiervorrichtung 7 angeordnet, daß diese vollständig mit dem Medium 9 umschlossen ist, d.h., daß der Flüssigkeitsspiegel des Mediums 9 oberhalb der Aufnahmevorrichtung 4 liegt. Weiters weist die Temperiervorrichtung 7 eine Regelund/oder Steuervorrichtung 10 zum Steuern bzw. Regeln der Temperatur des Mediums 9 auf. Um das Medium 9 beheizen zu können, weist die Temperiervorrichtung 7 zumindest eine Heizvorrichtung 11 auf, über die das Medium 9 bei Beaufschlagung mit Energie auf eine voreinstellbare Nenntemperatur aufgeheizt werden kann bzw. auf der entsprechenden Nenntemperatur gehalten werden kann. Selbstverständlich ist es möglich, daß jede beliebige Ausbildung der Temperiervorrichtung 7 mit einem flüssigen Medium 9 eingesetzt werden kann.

Weiters ist in der Temperiervorrichtung 7 eine Zufuhr- und Transportvorrichtung 12 angeordnet, sodaß die Widerstandskörper 2 von einer externen Zufuhrvorrichtung 13 über die Zufuhr- und Transportvorrichtung 12 an die Aufnahmevorrichtung 4 befördert werden kann. Die Zufuhr- und Transportvorrichtung 12 ist durch eine Scheibe 14 gebildet. Die Scheibe 14 weist stirnseitig um den Umfang verlaufende Schlitze 15 auf, in denen über die Zufuhrvorrichtung 13 die Widerstandskörper 2 eingefüllt bzw. eingesteckt werden, wodurch bei einer Rotation der Scheibe 14 die Widerstandskörper 2 zur Aufnahmevorrichtung 4 transportiert werden. Weiters weist die Scheibe 14 eine Öffnung 16, die um 90° versetzt zum Schlitz 15 angeordnet ist, auf. Durch die Anordnung der Öffnung 16 ist es möglich, daß die Aufnahmevorrichtung 4 über Kontaktstifte 17 mit den Widerstandskörpern 2 kontaktiert werden kann, wobei diese durch die Öffnung 16 in die Scheibe 14 eindringen und somit einen Kontakt mit dem Widerstandskörper 2 bilden, sodaß über die Meßvorrichtung 5 eine Messung des Widerstandswertes bei vorgegeben der Temperatur durchgeführt werden kann.

Die Scheibe 14 ist über eine Welle 18 im Aufnahmebecken 8 der Temperiervorrichtung positioniert und ragt zumindest teilweise in das Medium 9 der Temperiervorrichtung 7. Damit nunmehr die Scheibe 14 die einzelnen Widerstandskörper 2 von der Zufuhrvorrichtung 13 zur Aufnahmevorrichtung 4 befördern kann, wird die Scheibe 14 über einen Schrittmotor 19, der mit der Welle 18 gekuppelt ist, angetrieben.

Damit die Position der einzelnen Schlitze 15 von einer Steuervorrichtung 20 ermittelt werden kann, ist im Bereich der Scheibe 14 eine Nullpunktvorrichtung 21 angeordnet. Die Nullpunktvorrichtung 21 wird durch einen Nullpunktsensor 22 und einen an der Scheiben 14 angeordneten Kontakt 23 aufgebaut. Bewegt sich nunmehr aufgrund der Ansteuerung des Schrittmotors 19 der Kontakt 23 am Nullpunktsensor 22 vorbei bzw. liegen sich der Kontakt 23 und der Nullpunktsensor 22 gegenüber, so kann die Steuervorrichtung 20 aufgrund eines Signals vom Nullpunktsensor 22, erkennen, daß ein spezieller Schlitz 15 der Scheibe 14, insbesondere der erste Schlitz 15 am Nullpunktsensor 22 angelangt ist, wodurch über die Steuervorrichtung 20 die restlichen Positionen der einzelnen Schlitze 15 errechnet werden können.

Damit nunmehr eine Messung der Widerstandskörper 2 über die Aufnahmevorrichtung 4 durchgeführt werden kann, ist die Aufnahmevorrichtung 4 derartig im Aufnahmebecken 8 angeordnet, daß diese über eine Haltevorrichtung 24 in einer vorbestimmbaren Position zu einer Öffnung 16 der Scheibe 14 gehalten wird, sodaß die Kontaktstifte 17 in die Öffnungen 16 der Scheibe 14 eindringen können. Die Haltevorrichtung 24 kann dabei beliebig ausgeführt werden, wobei jedoch darauf geachtet werden muß, daß bei der Anordnung der Haltevorrichtung 24 eine exakte Position für die Aufnahmevorrichtung 4 gegeben sein muß.

Damit nunmehr ein gemessener Widerstandskörper 2 aus der Scheibe 14, insbesondere aus den Schlitzen 15 entnommen werden kann, ist im oberen Bereich also außerhalb des Mediums 9 eine Ausgabevorrichtung 25 angeordnet. Die Ausgabevorrichtung 25 kann beispielsweise durch eine einfache, zum Stand der Technik zählende Sortiervorrichtung 26 gebildet werden. An der Ausgabevorrichtung 25, insbesondere an der Sortiervorrichtung 26 sind anschließend mehrere Ausgänge angeordnet, über die die einzelnen Widerstandskörper 2 in verschiedene Behälter 27 bis 29, die beispielsweise unterschiedlichen Meßbereichen 30 bis 32 für die Widerstandskörper 2 entsprechen, ausgegeben werden können.

Die einzelnen Komponenten der Meß- und Sortieranlage 1 sind über mehrere Leitungen 33 mit der Steuervorrichtung 20 verbunden, wobei jedoch der Übersicht halber jeweils nur eine Leitung 33 dargestellt ist. Über diese Leitung 33 werden von der Steuervorrichtung 20 einzelne Befehle bzw. Daten an die einzelnen Komponenten der Meßund Sortieranlage 1 weitergeleitet bzw. werden die einzelnen Meßergebnisse oder Vorgänge von den einzelnen Komponenten an die Steuervorrichtung 20 übermittelt. Die Steuervorrichtung 20 kann beispielsweise durch eine handelsübliche, zum Stand der Technik zählende Mikroprozessorschaltung oder durch einen Personal Computer gebildet werden.

Am Beginn der Meß- und/oder Sortieranlage 1 wird von der Steuervorrichtung 20 zuerst die Temperiervorrichtung 7 aktiviert. Dazu ist es möglich, daß über die Leitung 33 von der Steuervorrichtung 20 ein entsprechender Sollwert für die Nenntemperatur an die Regel- und/oder Steuervorrichtung 10 der Temperiervorrichtung 7 übergeben wird. Daraufhin wird von der Regel- und/oder Steuervorrichtung 10 die Heizvorrichtung 11 mit Energie beaufschlagt, sodaß das Medium 9, das sich im Aufnahmebecken 8 befindet, auf die voreingestellte Nenntemperatur erwärmt wird. Dies ist deshalb notwendig, da die Messung der einzelnen Widerstandskörper 2 im Nenntemperaturbereich durchgeführt wird, d.h., daß der Widerstandskörper 2 durch die Anordnung der Zufuhr- und Transportvorrichtung 12, insbesondere der Scheibe 14 in dem Medium 9 auf die voreingestellte Nenntemperatur erhitzt wird, sodaß eine Messung des Widerstandswertes des Widerstandskörpers 2 im Nenntemperaturbereich erfolgt. Nachdem das Medium 9 auf die voreingestellte Nenntemperatur aufgeheizt wurde, wird von der Regelund/oder Steuervorrichtung 10 über die Leitung 33 ein Rücksignal an die Steuervorrichtung 20 gesandt, sodaß die Meß- und/oder Sortieranlage 1 zum Messen der Widerstandskörper 2 aktiviert werden kann.

Nachdem die Temperiervorrichtung 7 auf die voreingestellte Nenntemperatur aufgeheizt wurde, wird von der Steuervorrichtung 20 die Zufuhrvorrichtung 13 aktiviert, sodaß ein Widerstandskörper 2 in den Schlitz 15 der Scheibe 14 befördert wird. Dazu weist die Zufuhrvorrichtung 13 ein Vereinzelungsmodul 34 auf. Das Vereinzelungsmodul 34 kann beispielsweise durch einen Rüttler gebildet werden, wodurch mehrere Widerstandskörper 2 in das Vereinzelungsmodul 34 transportiert werden können und anschließend die Abgabe der Widerstandskörper 2 einzeln an die Scheibe 14 bzw. an die Zufuhr- und Transportvorrichtung 12 erfolgt. Die Zufuhrvorrichtung 13 kann beispielsweise zur Abgabe der einzelnen Widerstandskörper 2 über die Steuervorrichtung 20 angesteuert werden, d.h., daß beispielsweise beim Beaufschlagen des Schrittmotors 19 von der Steuervorrichtung 20 gleichzeitig die Zufuhrvorrichtung 13 aktiviert wird, sodaß von dieser wiederum ein Widerstandskörper 2 an die Scheibe 14 zugeführt wird.

Nachdem von der Zufuhrvorrichtung 13 ein Widerstandskörper 2 an die Zufuhr- und Transportvorrichtung 12 abgegeben wurde, wird von der Steuervorrichtung 20 der Schrittmotor 19 beaufschlagt. Durch das Ansteuern des Schrittmotors 19 wird die Scheibe 14 entsprechend einem Pfeil 35 bewegt, sodaß ein weiterer Schlitz 15 der Scheibe 14 im Übergabebereich zu der Zufuhrvorrichtung 13 positioniert wird. Daraufhin wird von der Steuervorrichtung 20 ein Steuerbefehl zur Abgabe eines Widerstandskörpers 2 angelegt, wodurch ein weiterer Widerstandskörper 2 von der Zufuhrvorrichtung 13, insbesondere vom Vereinzelungsmodul 34 an die Scheibe 14 übergeben wird. Dieser Vorgang wird solange wiederholt, bis der erste Widerstandskörper 2 die Aufnahmevorrichtung 4 der Meßstation 3 erreicht hat.

Damit die Steuervorrichtung 20 die einzelnen Positionen der Widerstandskörper 2 in den Schlitzen 15 der Scheibe 14 erkennen kann, wird über die Nullpunktvorrichtung 21 vor Beginn eines Meßzykluses bzw. des Befüllens der Scheibe 14 eine Initialisierung der Scheibe 14 durchgeführt. Dies kann beispielsweise derart erfolgen, daß die Scheibe 14 über den Schrittmotor 19 solange angesteuert wird, bis der Kontakt 23 für den Nullpunktsensor 22 am Nullpunktsensor 22 angelangt ist, wodurch vom Nullpunktsensor 22 ein Signal an die Steuervorrichtung 20 übergeben wird. Darauf hin kann nunmehr von der Steuervorrichtung 20 jeder beliebige Schlitz 15 der Scheibe 14 errechnet werden, da aufgrund der Ansteuerung des Schrittmotors 19 die exakte Position des ersten Schlitzes 15 von der Steuervorrichtung 20 über die einzelnen Impulse an den Schrittmotor 19 errechnet werden kann.

Nachdem von der Zufuhrvorrichtung 13 die Scheibe 14 der Zufuhr- und Transportvorrichtung 12 solange mit Widerstandskörpern 2 befüllt wurde, bis der erste Widerstandskörper 2 im Bereich der Aufnahmevorrichtung 4 angelangt ist, wird von der Steuervorrichtung 20 ein Impuls an die Meßstation 3 übergeben. Durch die Aktivierung der Meßstation 3 erfolgt nun eine Messung des Widerstandswertes des Widerstandskörpers 2. Dazu wird von der Meßstation 3 die Aufnahmevorrichtung 4 über die Leitung 6 aktiviert, sodaß die einzelnen Kontaktstifte 17 der Aufnahmevorrichtung 4 mit dem Widerstandskörper 2 in Verbindung gebracht werden. Dazu ist die Aufnahmevorrichtung 4 derartig ausgebildet, daß beidseits der Scheibe 14 zwei Haltearme 36, 37 angeordnet sind, an die die einzelnen Kontaktstifte 17 angeordnet sind. Die beiden Haltearme 36, 37 sind über eine Führungswelle 38 miteinander verbunden. Beim Aktivieren der Aufnahmevorrichtung 4 werden nunmehr die Haltearme 36, 37 entlang der Führungswelle 38 in Richtung der Scheibe 14 bewegt, sodaß die Kontaktstifte 17 durch die Öffnung 16 in die Scheibe 14 eindringen, wodurch eine Kontaktierung des Widerstandskörpers 2 über die Kontaktstifte 17 erfolgt. Dabei ist es möglich, daß zumindest ein Kontaktstift 17 an jedem Haltearm 36, 37 angeordnet ist. Damit jedoch eine exakte Messung des Widerstandskörpers 2 durchgeführt werden kann, ist es vorteilhaft, wenn zumindest vier Kontaktstifte 17 zum Messen des Widerstandswertes des Widerstandskörpers 2 verwendet werden. Dazu sind jeweils auf einem Haltearm 36, 37 zwei Kontaktstifte 17 angeordnet.

Nachdem die Aufnahmevorrichtung 4 mit dem Widerstandskörper 2 kontaktiert wurde, wird von der extern angeordneten Meßvorrichtung 5 der Widerstandswert des Widerstandskörpers 2 gemessen. Das Messen des Widerstandswertes des Widerstandskörpers 2 kann durch jedes beliebige, aus dem Stand der Technik bekannte Verfahren durchgeführt werden. Das Meßergebnis wird anschließend über eine Leitung 39 an eine Auswerteeinheit 40 übergeben. Dabei ist es möglich, daß die Auswerteeinheit 40 direkt in der Steuervorrichtung 20 angeordnet ist.

Nachdem der gemessene Widerstandswert des Widerstandskörpers 2 an die Auswerteeinheit 40 übergeben wurde, wird von der Steuervorrichtung 20 bzw. von der Auswerteeinheit 40 ein Soll-Ist-Vergleich durchgeführt, d.h., daß der gemessene Widerstandswert mit einem in der Steuervorrichtung 20 voreingestellten Sollwert verglichen wird. Daraufhin wird die prozentuelle Abweichung des gemessenen Widerstandswertes von dem vorgegebenen Sollwert ermittelt.

Durch die Messung des Widerstandswertes bei Nenntemperatur wird erreicht, daß diese Widerstandskörper 2 bei einer entsprechenden Temperatur einen exakten Wert aufweisen. Das Einsatzgebiet von derartigen Widerstandskörpern 2 liegt beispielsweise bei Klimaanlagen oder temperaturgesteuerten Regel- und/oder Steuervorrichtungen, die bei einer bestimmten Temperatur einen Regelvorgang oder Steuervorgang durchführen müssen, wobei zur Aktivierung der Regelung bzw. Steuerung ein entsprechend auf diese Temperatur abgestimmter Widerstand mit dem darin enthaltenen Widerstandskörper 2 eingesetzt wird.

Nachdem die Auswertung in der Auswerteeinheit 40 bzw. in der Steuervorrichtung 20 abgeschlossen ist, wird wiederum der Schrittmotor 19 aktiviert, sodaß sich die Scheibe 14 entsprechend dem Pfeil 35 um eine Position verdreht. Von der Steuervorrichtung 20 wird dabei der zuvor gemessene Widerstandswert bzw. die prozentuelle Abweichung mit der Position des Schlitzes 15 der Scheibe 14 in einem Speicher hinterlegt. Dabei ist es möglich, daß bei jeder Ansteuerung des Schrittmotors 19 von der Steuervorrichtung 20 die Position im Speicher ebenfalls geändert wird. Bei Übereinstimmung einer Position eines Schlitzes 15, in dem sich bereits ein gemessener Widerstandskörper 2 befindet, mit der Ausgabevorrichtung 25 wird von der Steuervorrichtung 20 die Ausgabevorrichtung 25 aktiviert und gleichzeitig werden die entsprechenden Daten des Widerstandskörpers 2 an die Ausgabevorrichtung 25 übergeben. Durch das Speichern der gemessenen Widerstandswerte bzw. der prozentuellen Abweichung mit der Position des Schlitzes 15 der Scheibe 14 ist es möglich, daß mehrere Meßvorgänge mit der Meßstation durchgeführt werden, bevor der erste Widerstandskörper 2 aus der Zufuhrund Transportvorrichtung 12 entfernt wird.

Stimmt nunmehr die Position des Schlitzes 15 mit einem in diesem angeordneten Widerstandskörper 2 überein, so wird von der Steuervorrichtung 20 die Ausgabevorrichtung 25 bzw. die Sortiervorrichtung 26 aktiviert. Dabei wird der Widerstandskörper 2 aus dem Schlitz 15 der Scheibe 14 entnommen. Dies kann beispielsweise durch eine Vakuumvorrichtung erfolgen. Gleichzeitig mit der Ansteuerung der Ausgabevorrichtung 25 bzw. der Sortiervorrichtung 26 wird von der Steuervorrichtung 20 die entsprechend für diesen Widerstandskörper 2 gespeicherten Daten übermittelt, d. h., daß von der Steuervorrichtung 20 die prozentuelle Abweichung des gemessenen Widerstandskörpers 2 an die Ausgabevorrichtung 25 bzw. an die Sortiervorrichtung 26 übergeben wird. Von der Sortiervorrichtung 26 wird nunmehr der Widerstandskörper 2 entsprechend den übergebenen Daten an einen entsprechenden Behälter 27 bis 29 weitergeleitet. Die einzelnen Behälter 27 bis 29 entsprechen dabei unterschiedlichen Bereichen, insbesondere Meßbereichen 30 bis 32 der prozentuellen Abweichung, d. h., daß beispielsweise in dem Behälter 27 die Widerstandskörper 2 mit nur 1 % Abweichung, in dem Behälter 28 die Widerstandskörper 2 mit 3 % Abweichung und in dem Behälter 29 jene Widerstandskörper 2, die keinem der beiden zuvor festgelegten Meßbereiche 30, 31 zuordenbar sind, zugeteilt werden.

Der Vorteil bei einer derartigen Meß- und Sortieranlage 1 liegt darin, daß die Messung des Widerstandswertes bei Nenntemperatur durchgeführt wird, wobei zum Aufheizen des Widerstandskörpers 2 auf die Nenntemperatur dies über ein Medium 9 geschieht, wodurch äußere Einflüsse, wie beispielsweise die Luftfeuchtigkeit oder die Außentemperatur nicht berücksichtigt werden müssen und somit eine exakte Messung durchgeführt werden kann.

Weiters ist es möglich, daß bei einer derartigen Meß- und Sortieranlage 1 vor der Ausgabevorrichtung 25 oder nach dieser eine Bearbeitungsvorrichtung 41, wie dies schematisch mit strichlierten Linien dargestellt ist, angeordnet ist. Die Bearbeitungsvorrichtung 41 hat dabei die Aufgabe, bei Nichtübereinstimmung des Widerstandswertes mit dem entsprechenden Sollwert, den Widerstandskörper 2 aus der Scheibe 14 zu entnehmen und derart zu bearbeiten, daß der Widerstandswert an den entsprechenden Sollwert angepaßt wird. Dazu wird von der Steuervorrichtung 20 wiederum bei Übereinstimmung der Position des Schlitzes 15 mit der Position der Bearbeitungsvorrichtung 41 die Bearbeitungsvorrichtung 41 aktiviert, sodaß der Widerstandskörper 2 aus der Scheibe 14 entnommen wird und in der Bearbeitungsvorrichtung 41 durch Schleifen oder thermische Behandlung beispielsweise durch einen Laser oder durch Aufbringen von Körpermasse an den Sollwert angepaßt wird. Dazu wird zuerst von der Bearbeitungsvorrichtung 41 die Körpermasse des Widerstandskörpers 2 beispielsweise durch ein Bildverarbeitungssystem ermittelt. Die Daten werden anschließend an ein Logikmodul der Bearbeitungsvorrichtung 41 übergeben.

Gleichzeitig mit dem Aktivieren der Bearbeitungsvorrichtung 41 wird von der Steuervorrichtung 20 die prozentuelle Abweichung an das Logikmodul übersandt, sodaß dieses nunmehr einen Korrekturfaktor im Bezug auf die Körpermasse des Widerstandskörpers 2 errechnen kann. Durch mechanische oder thermische Bearbeitung des Widerstandskörpers 2 wird anschließend der Widerstandskörper 2 entweder durch Auftragen oder Abtragen von Körpermasse an den Sollwert angepaßt.

Nachdem der Widerstandskörper 2 von der Bearbeitungsvorrichtung 41 bearbeitet wurde, wird dieser wieder in den gleichen oder einen anderen Schlitz 15 der Scheibe 14 übergeben, wobei bei der Übergabeposition zur Ausgabevorrichtung 25 dieser nicht mehr von der Ausgabevorrichtung 25 entnommen wird, sondern wird dieser über die Ausgabevorrichtung 25 hinwegbewegt und gelangt somit wieder zur Meßstation 3. Von der Meßstation 3 wird der Widerstandswert des Widerstandskörpers 2 abermals über die Meßvorrichtung 5 gemessen. Dieser Vorgang kann mehrere Male durchgeführt werden. Selbstverständlich ist es möglich, daß eine maximale Anzahl von Umläufen eines Widerstandskörpers 2 eingestellt werden kann, sodaß bei erreichen des maximalen Umlaufes von beispielsweise 3 Umläufen, der Widerstandskörper 2 in den Behälter 29, in dem sich die Ausschußware befindet, ausgegeben wird.

Bei dem zuvor beschriebenen Ausführungsbeispiel ist es beispielsweise möglich, daß die Zufuhr- und Transportvorrichtung 12, insbesondere die Scheibe 14 aus mehreren Einzelscheiben gebildet wird, wobei die Einzelscheiben derartig ausgebildet sind, daß beispielsweise die mittlere Einzelscheibe die Schlitze 15 und die beiden äußeren Einzelscheiben die Öffnungen 16 aufweisen. Die Einzelscheiben werden anschließend miteinander verbunden, sodaß wiederum von der Zufuhrvorrichtung 13 die Widerstandskörper 2 stirnseitig in die Schlitze 15 übergeben werden können.

Weiters ist es möglich, daß zur Erkennung der Schlitze 15 auf der Scheibe 14 für jeden Schlitz 15 ein Erkennungszeichen, insbesondere ein Strichcode angeordnet ist, sodaß über eine entsprechende Lesevorrichtung der Schlitz 15 identifiziert werden kann. Dabei kann beispielsweise jede mit der Zufuhr- und Transportvorrichtung 12 in Verbindung stehende Komponente eine eigene Lesevorrichtung aufweisen. Dadurch ist es möglich, daß die einzelnen Komponenten nach dem Lesevorgang sich die Daten für den im Schlitz 15 befindlichen Widerstandskörper 2 aus einem zentralen Speicher auslesen können und entsprechend den Daten die einzelnen Steuerabläufe durchführen können. Selbstverständlich ist es möglich, daß nur eine Lesevorrichtung angeordnet sein kann, von der aus dann jede Position des Schlitzes 15 über die Steuervorrichtung 20 bzw. von jeder eigenen Komponente errechnet werden kann.

Es ist weiters auch möglich, daß zur Feststellung eines Widerstandskörpers 2 in einem Schlitz 15 die Scheibe 14 eine optische Erkennungsvorrichtung aufweisen kann, die mit der Steuervorrichtung 20 verbunden ist. Die optische Erkennungsvorrichtung kann derartig aufgebaut werden, daß an einer Seite der Scheibe 14 ein Sender und an der gegenüberliegenden Seite ein Empfänger angeordnet ist. Um nun feststellen zu können, ob sich ein Widerstandskörper 2 im Schlitz 15 befindet, wird von einem Sender ein Lichtsignal durch eine der Öffnungen 16 der Scheibe 14 ausgesandt, wobei bei Auftreffen des Lichtsignals an einen Empfänger die Erkennungsvorrichtung beispielsweise ein Signal an die Steuervorrichtung 20 weiterleitet, sodaß die Steuervorrichtung 20 erkennen kann, daß sich in diesem Schlitz 15 der Scheibe 14 kein Widerstandskörper 2 befindet. Selbstverständlich kann zum Erkennen des Widerstandskörpers 2 im Schlitz 15 auch eine mechanische Erkennungsvorrichtung, die beispielsweise durch einen Fühler gebildet wird, eingesetzt werden.

Weiters ist es möglich, daß die Widerstandskörper 2 selbständig in der Zufuhr- und Transportvorrichtung 12 kontaktiert werden, sodaß die Öffnungen 16 für die Schlitze 15 entfallen können. Hierzu sind in den Schlitzen 15 Kontaktpunkte angeordnet, die beim Befüllen eines Schlitzes 15 mit einem Widerstandskörpers 2 selbständig kontaktieren. Die Kontaktpunkte können beispielsweise über in den Scheiben 14 integrierte Leitungen nach außen gezogen werden, sodaß eine Kontaktierung zum Messen des Widerstandskörpers 2 auf der Außenseite der Scheibe 14 über die Aufnahmevorrichtung 4 erfolgt.

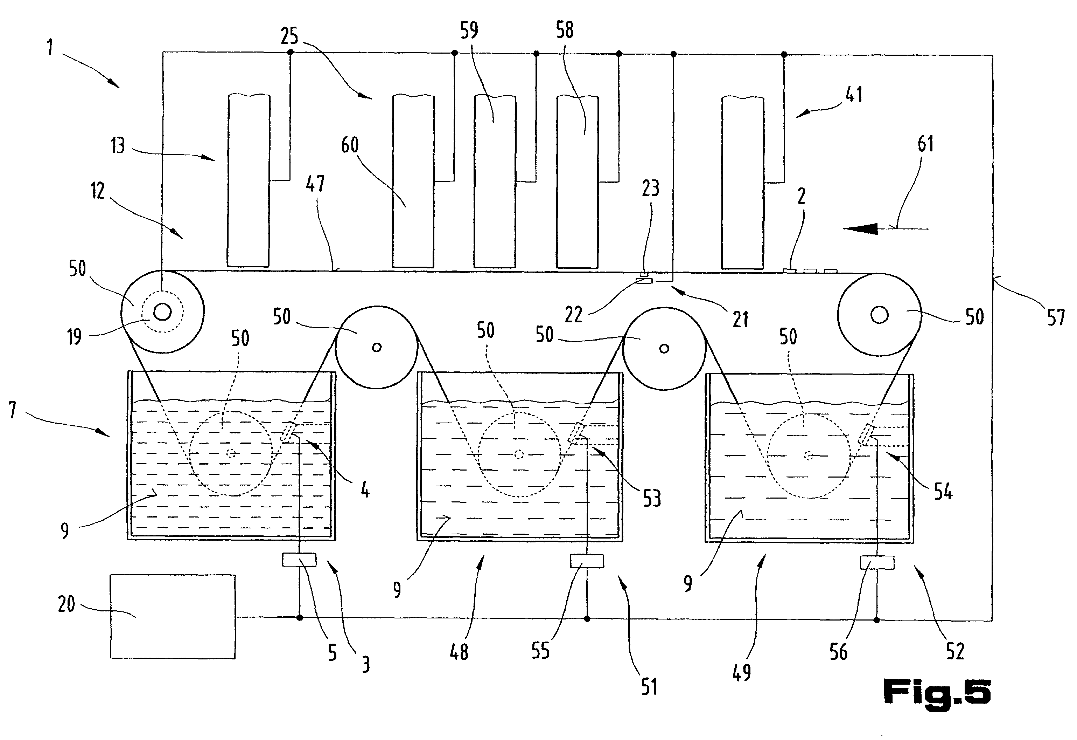

In Fig. 4 ist ein weiteres Ausführungsbeispiel der Meß- und/oder Sortieranlage 1 gezeigt, wobei hier wiederum nur die Temperiervorrichtung 7 in Stirnansicht, geschnitten, dargestellt ist.

Bei dem dargestellten Ausführungsbeispiel ist wiederum die Zufuhr- und Transportvorrichtung 12, insbesondere die Scheibe 14 auf der Welle 18 im Innenraum der Temperiervorrichtung 7 angeordnet. Die Zufuhr- und Transportvorrichtung 12 ragt teilweise in das nicht leitende Medium 9 der Temperiervorrichtung 7.

Entsprechend den zuvor beschriebenen Fig. 1 bis 3 ist die Aufnahmevorrichtung 4 der Meßstation 3 im Inneren des Aufnahmebeckens 8 der Temperiervorrichtung 7 angeordnet, wobei das Medium 9 wiederum die Aufnahmevorrichtung 4 vollständig umschließt.

Der Unterschied zu dem zuvor beschriebenen Ausführungsbeispiel liegt nun darin, daß in der Temperiervorrichtung 7 eine weitere Zufuhr- und Transportvorrichtung 42 in der Temperiervorrichtung 7 angeordnet ist. Die Zufuhr- und Transportvorrichtung 42 wird wiederum durch eine Scheibe 43 mit einem darin befindlichen Schlitz 44 und einer Öffnung 45 gebildet. Der weiteren Zufuhr- und Transportvorrichtung 42, insbesondere der Scheibe 43 ist wiederum eine Aufnahmevorrichtung 46 zugeteilt.

Die Funktion dieses Ausführungsbeispiels entspricht dabei der Funktion, wie sie in den Fig. 1 bis 3 beschrieben ist, wobei nunmehr anstelle einer Zufuhrvorrichtung 13 und einer Ausgabevorrichtung 25 bzw. einer Bearbeitungsvorrichtung 41 nunmehr für jede Scheibe 14, 43 eine eigene Zufuhrvorrichtung 13, Ausgabevorrichtung 25 bzw. Bearbeitungsvorrichtung 41 angeordnet ist. Die Scheibe 43 ist ebenfalls auf der Welle 18 angeordnet, sodaß durch Aktivierung des Schrittmotors 19 beide Scheiben 14, 43 im gleichen Rhythmus bewegt werden. Dadurch ist es möglich, daß nur eine Nullpunktvorrichtung 21 angeordnet werden muß, wobei diese bei dem dargestellten Ausführungsbeispiel im Bereich der Scheibe 14 positioniert ist. Selbstverständlich ist es möglich, daß die Nullpunktvorrichtung 21 im Bereich der Scheibe 43 angeordnet sein kann. Es ist auch möglich, daß die Scheibe 43 auf eine eigene Welle 18 mit einem dieser Welle 18 zugeordneten Schrittmotor 19 sein kann, sodaß die beiden Scheiben 14, 43 unabhängig betrieben werden können. Dazu ist jedoch erforderlich, daß für jede Scheibe 14, 43 eine Nullpunktvorrichtung 21 bzw. eine andere Vorrichtung zum Erkennen der Schlitze 15, 44 beispielsweise, eine Strichcodelesevorrichtung zugeordnet wird.

Der Vorteil einer derartigen Anordnung von mehreren, insbesondere von zwei Scheiben 14, 43 in der Temperiervorrichtung 7 liegt darin, daß nunmehr in einem Meßzyklus zwei Widerstandskörper 2 gleichzeitig gemessen werden können. Selbstverständlich ist es möglich, daß mehr als nur zwei Zufuhr- und Transportvorrichtungen 12, 42, insbesondere die Scheiben 14, 43 in der Temperiervorrichtung 7 angeordnet sein können, wobei für jede Zufuhr- und Transportvorrichtung 12, 42 jeweils eine Zufuhrvorrichtung 13, eine Ausgabevorrichtung 25 oder eine Bearbeitungsvorrichtung 41 angeordnet sein kann.

Es ist jedoch auch möglich, daß nur eine Zufuhrvorrichtung 13, eine Ausgabevorrichtung 25 oder eine Bearbeitungsvorrichtung 41 für mehrere Scheiben 14, 43 angeordnet sein können, wobei diese über Führungen parallel zu den einzelnen Scheiben 14, 43 verfahren werden, sodaß ein serielles Befüllen der Zufuhr- und Transportvorrichtung 12, 42 bzw. ein serielles Messen, Bearbeiten oder Entnehmen der Widerstandskörper 2 durchgeführt werden kann.

In Fig. 5 ist ein weiters Ausführungsbeispiel der Meß- und Sortieranlage 1 gezeigt. Bei dem dargestellten Ausführungsbeispiel wird die Zufuhr- und Transportvorrichtung 12 durch ein Transportband 47 bzw. durch einen Transportgurt gebildet. Das Transportband 47 kann dabei derartig aufgebaut werden, daß es einem offenen Plistergurt entspricht, d.h., daß im Transportband 47 Vertiefungen angeordnet sind, in denen die Widerstandskörper 2 von der Zufuhrvorrichtung 13 abgelegt werden, sodaß ein Transport der Widerstandskörper 2 möglich ist. Selbstverständlich ist es möglich, daß anstelle des Transportbandes 47 ein Plistergurt, in dem die Widerstandskörper 2 bzw. die Widerstände integriert sind, in die Meß- und Sortieranlage 1 eingespannt werden kann.

Bei derartigen Meß- und Sortieranlagen 1 sind nun mehrere Temperiervorrichtungen 7, 48, 49 angeordnet, die über das Transportband 47 miteinander verbunden sind, d.h., daß das Transportband 47 sich von der Temperiervorrichtung 7 über Umlenkrollen 50 in die weiteren Temperiervorrichtungen 48, 49 erstreckt, wobei sich anschließend das Transportband 47 über weitere Umlenkrollen 50 zur Temperiervorrichtung 7 zurückerstreckt und somit den Kreis schließt. Weiters ist in jeder Temperiervorrichtung 7, 48, 49 eine eigene Meßstation 3, 51, 52, die wiederum durch eine Aufnahmevorrichtung 4, 53, 54 und eine Meßvorrichtung 5, 55, 56 gebildet ist, angeordnet. Die einzelnen Meßvorrichtungen 5, 55, 56 bzw, die Meßstationen 3, 51, 52 sind über ein Bussystem 57 mit der Steuervorrichtung 20 verbunden. Das Bussystem 57 kann durch jedes beliebige zum Stand der Technik zählende, serielles oder paralleles Bussystem gebildet werden. Selbstverständlich ist es möglich, daß die in diesem Ausführungsbeispiel verwendeten Komponenten direkt an der Steuervorrichtung 20 angeschlossen sind.

Weiters sind dem Transportband 47 die Zufuhrvorrichtung 13, die Bearbeitungsvorrichtung 41 sowie die Ausgabevorrichtung 25, die nunmehr aus drei Ausgängen 58 bis 60 gebildet ist, zugeordnet. Wie schematisch dargestellt, sind die einzelnen Komponenten der Zufuhrvorrichtung 13 der Ausgabevorrichtung 25 und der Bearbeitungsvorrichtung 41 ebenfalls über das Bussystem 57 mit der Steuervorrichtung 20 verbunden. Weiters ist am Transportband 47 die Nullpunktvorrichtung 21 angeordnet, wobei die Nullpunktvorrichtung wiederum durch den Kontakt 23 und den Nullpunktsensor 22 gebildet wird.

Bei der Inbetriebnahme einer derartigen Meß- und Sortieranlage 1 wird wie in den zuvor beschriebenen Fig. 1 bis 4 grundsätzlich derselbe Funktionsablauf durchgeführt, wobei zuerst das Medium 9 der einzelnen Temperiervorrichtungen 7, 48, 49 auf eine voreinstellbare Nenntemperatur aufgeheizt wird. Bei diesem Ausführungsbeispiel werden die Medien 9 der einzelnen Temperiervorrichtungen 7, 48, 49 auf unterschiedliche Nenntemperaturen aufgeheizt.

Dazu wird von der Steuervorrichtung 20 über das zum Stand der Technik zählende Bussystem 57 ein Steuersignal an die Zufuhrvorrichtung 13 weitergeleitet, wodurch ein Widerstandskörper 2 am Transportband 47 positioniert wird. Anschließend wird von der Steuervorrichtung 20 der Schrittmotor 19, welcher ebenfalls über das Bussystem 57 mit der Steuervorrichtung 20 verbunden ist, angesteuert, sodaß das Transportband in Richtung eines Pfeils 61 bewegt wird. Daraufhin wird von der Steuervorrichtung 20 wiederum die Zufuhrvorrichtung 13 mit einem Signal beaufschlagt, wodurch der nächste Widerstandskörper 2 am Transportband 47 positioniert wird. Dieser Vorgang vom Positionieren der Widerstandskörper 2 wird solange durchgeführt, bis der erste Widerstandskörper 2 an der ersten Meßstation 3, insbesondere an der Aufnahmevorrichtung 4 angelangt ist. Daraufhin wird wie in den zuvor beschriebenen Figuren ein Meßvorgang im nicht leitenden Medium 9 bei einer voreingestellten Nenntemperatur durchgeführt. Nachdem von der Steuervorrichtung 20 die Auswertung über diesen Meßvorgang durchgeführt wurde, wird wiederum der Schrittmotor 19 mit einem Impuls beaufschlagt, sodaß sich dieser Widerstandskörper 2 nunmehr in Richtung der nächsten Temperiervorrichtung 47 weiterbewegt und ein neuer Widerstandskörper 2 am Transportband 47 durch Ansteuern der Zufuhrvorrichtung 13 positioniert wird.

Durch die Anordnung mehrerer Temperiervorrichtungen 7, 48, 49 ist es nunmehr möglich, daß die einzelnen Temperiervorrichtungen 7, 48, 49 unterschiedliche Nenntemperaturen aufweisen, wodurch eine Messung des Widerstandskörpers 2 bei unterschiedlichen Nenntemperaturen durchgeführt werden kann.

Nachdem eine Messung von einem Widerstandskörper 2 über die Meßstation 3, insbesondere die Meßvorrichtung 5 erfolgte, wird das Meßergebnis über das Bussystem 57 an die Steuervorrichtung 20 weitergeleitet. Hat nunmehr ein Widerstandskörper 2 alle Temperiervorrichtungen 7, 48, 49 und somit alle Meßstationen 3, 51, 52 durchlaufen, so wird bei Übereinstimmung der Position mit der Bearbeitungsvorrichtung 41 von der Steuervorrichtung 20 ein Signal an die Bearbeitungsvorrichtung 41 über das Bussystem 57 ausgesandt. Daraufhin wird wiederum von der Bearbeitungsvorrichtung 41 dieser Widerstandskörper 2 vom Transportband entnommen und über eine Bildverarbeitungsvorrichtung die Körpermasse dieses Widerstandskörpers 2 ermittelt. Gleichzeitig wurde mit dem Aktivieren der Bearbeitungsvorrichtung 41 die prozentuelle Abweichung dieses Widerstandskörpers 2 von der Steuervorrichtung 20 an die Bearbeitungsvorrichtung 41 übertragen. Durch die Ermittlung der Körpermasse und der übersandten, prozentuellen Abweichung dieses Widerstandskörpers 2 kann nunmehr von der Bearbeitungsvorrichtung 41 die Bearbeitung des Widerstandskörpers 2 durchgeführt werden. Dazu ist es wie in den zuvor beschriebenen Figuren möglich, daß verschiedene, zum Stand der Technik zählende Verfahren bzw. Vorrichtungen zum Bearbeiten von Widerstandskörpern 2 eingesetzt werden können. Es ist beispielsweise möglich, daß durch Schleifen bzw. thermische Behandlung, beispielsweise durch einen Laser oder durch Auftragen von Körpermasse der Widerstandswert an den vorgegebenen Sollwert angepaßt wird.

Nachdem die Bearbeitung des Widerstandskörpers 2 erfolgte, wird der Widerstandskörper 2 wieder auf dem Transportband 47 positioniert. Dabei ist es möglich, daß der Widerstandskörper 2 in die selbe Ausnehmung des Transportbandes 47 bzw. in eine andere Ausnehmung des Transportbandes 47 abgelegt wird, wobei vor dem Ablegen des Widerstandskörpers 2 von der Bearbeitungsvorrichtung 41 die Steuervorrichtung 20 kontaktiert wird, sodaß die Steuervorrichtung 20 ein Freisignal zum Ablegen am Transportband 47 über das Bussystem 57 der Bearbeitungsvorrichtung 41 übersendet. Dies ist deshalb notwendig, da aufgrund der großen Anzahl von unterschiedlichen Positionen am Transportband 47 die Steuervorrichtung 20 die Position jedes einzelnen Widerstandskörpers 2 am Transportband 47 errechnen können muß, da für die Abgabe bzw. für die Ausgabevorrichtung 25 ein entsprechender Impuls erzeugt werden muß.

Nachdem jedoch der Widerstandskörper 2 von der Bearbeitungsvorrichtung 41 bearbeitet wurde, muß dieser Widerstandskörper 2 die Meßstationen 3, 51, 52 abermals durchlaufen, bevor er über die Ausgabevorrichtung 25 vom Transportband 47 entnommen werden kann. Entspricht ein Widerstandskörper 2 den vorgegebenen Toleranzbereichen, so wird die Ausgabevorrichtung 25 aktiviert. Dabei ist es nun möglich, daß die Entnahme des Widerstandskörpers 2 über die drei Ausgänge 58 bis 60 von der Steuervorrichtung 20 gesteuert wird. Die drei Ausgänge 58 bis 60 der Ausgabevorrichtung 25 haben dabei die Aufgabe, den Widerstandskörper 2 entsprechend den Toleranzbereichen in den unterschiedlichsten Behältern abzulegen. Dabei ist es beispielsweise möglich, daß der Ausgang 58 für Widerstandskörper 2, die nur 1 % Abweichung haben, verwendet wird, wogegen beispielsweise der Ausgang 59 für Widerstandskörper 2 mit 3 %igen Abweichungen und der Ausgang 60 für Widerstandskörper 2 mit 5 %igen Abweichungen herangezogen werden können.

Die exakte Funktionsbeschreibung des Meßvorganges bzw. der Entnahme oder Bearbeitung sowie der Zuführung der Widerstandskörper 2 kann aus den Fig. 1 bis 3 entnommen werden.

Der Vorteil einer derartigen Meß- und Sortieranlage 1 liegt nun darin, daß der Widerstandskörper 2 in unterschiedlichen Nenntemperaturen gemessen werden kann. Dazu werden die einzelnen Temperiervorrichtungen 7, 48, 49 auf unterschiedliche Temperaturen aufgeheizt, sodaß eine Temperaturkurve mit einem entsprechenden Widerstandswert für jeden Widerstandskörper 2 erstellt werden kann.

Selbstverständlich ist es möglich, daß am Transportband 47 mehrere parallel zueinander angeordnete Widerstandskörper 2 angeordnet sein können. Dazu kann für jeden Widerstandskörper 2 eine eigene Aufnahmevorrichtung 4, 53, 54 oder eine gemeinsame Aufnahmevorrichtung 4, 53, 54, die über Führungen verfahrbar ist, angeordnet sein. Die Kontaktierung der Widerstandskörper 2 über die Aufnahmevorrichtung 4, 53, 54 erfolgt wie in den zuvor beschriebenen Fig. 1 bis 3 über die Kontaktstifte 17.

Selbstverständlich ist es auch möglich, daß für die einzelnen Meßstationen 3, 51, 52 eigenständige Steuervorrichtungen 20 angeordnet sein können. Diese einzelnen Steuervorrichtungen 20 werden anschließend über Leitungen oder ein Bussystem 57 miteinander verknüpft, sodaß ein entsprechender Datenaustausch untereinander durchgeführt werden kann. Weiters ist es auch möglich, daß nach jeder Temperiervorrichtung 7, 48, 49 jeweils eine eigene Bearbeitungsvorrichtung 41 bzw. Ausgabevorrichtung 25 angeordnet ist, sodaß nach Durchlaufen einer oder zweier Temperiervorrichtungen 7, 48, 49 der Widerstandskörper 2 vom Transportband 47 entnommen werden kann. Es ist auch möglich, daß mehrere nebeneinander angeordnete Transportbänder 47 in den einzelnen Temperiervorrichtungen 7, 48, 49 angeordnet sind, wobei dabei jeweils nur eine Meßstation 3, 51, 52 oder jeweils eine eigenständige Meßstation 3, 51, 52 angeordnet ist. Weiters ist es möglich, daß die Aufnahmevorrichtung 4, 53, 54 derart ausgebildet ist, daß mehrere nebeneinander verlaufende Widerstandskörper 2 in einem Arbeitsschritt kontaktiert werden können.

Der Ordnung halber sei abschließend darauf hingewiesen, daß in den Zeichnungen einzelne Bauteile und Baugruppen zum besseren Verständnis der Erfindung nur schematisch dargestellt sind.

### Bezugszeichenaufstellung

- 1: Meß- und Sortieranlage
- 2: Widerstandskörper
- 3: Meßstation
- 4: Aufnahmevorrichtung
- 5: Meßvorrichtung

- 6: Leitung
- 7: Temperiervorrichtung
- 8: Aufnahmebecken
- 9: Medium
- 10: Regel- und/oder Steuervorrichtung

- 11: Heizvorrichtung
- 12: Zufuhr- und Transportvorrichtung
- 13: Zufuhrvorrichtung
- 14: Scheibe
- 15: Schlitz

- 16: Öffnung
- 17: Kontaktstift
- 18: Welle
- 19: Schrittmotor
- 20: Steuervorrichtung

- 21: Nullpunktvorrichtung
- 22: Nullpunktsensor
- 23: Kontakt
- 24: Haltevorrichtung
- 25: Ausgabevorrichtung

- 26: Sortiervorrichtung
- 27: Behälter
- 28: Behälter
- 29: Behälter
- 30: Meßbereich

- 31: Meßbereich
- 32: Meßbereich
- 33: Leitung
- 34: Vereinzelungsmodul
- 35: Pfeil

- 36: Haltearm
- 37: Haltearm
- 38: Führungswelle
- 39: Leitung
- 40: Auswerteeinheit

- 41: Bearbeitungsvorrichtung
- 42: Zufuhr- und Transportvorrichtung
- 43: Scheibe
- 44: Schlitz
- 45: Öffnung

- 46: Aufnahmevorrichtung
- 47: Transportband
- 48: Temperiervorrichtung
- 49: Temperiervorrichtung
- 50: Umlenkrolle

- 51: Meßstation
- 52: Meßstation
- 53: Aufnahmevorrichtung
- 54: Aufnahmevorrichtung
- 55: Meßvorrichtung

- 56: Meßvorrichtung
- 57: Bussystem
- 58: Ausgang
- 59: Ausgang
- 60: Ausgang

- 61: Pfeil

## Patentansprüche

1. Meß- und Sortieranlage zum Messen und Sortieren von Widerstandskörpern entsprechend ihren Widerstandswerten, mit einer scheibenförmig ausgebildeten Zufuhr- und Transportvorrichtung für die Widerstandskörper, einer Meßstation, einer dieser nachgeordneten Ausgabevorrichtung, und einer Temperiervorrichtung, die ein mit einem flüssigen Medium befülltes Aufnahmebecken aufweist, **dadurch gekennzeichnet, daß** die Meßstation (3, 51, 52) in der Temperiervorrichtung (7, 48, 49) angeordnet ist und die Position der Widerstandskörper (2) auf der Zufuhr- und Transportvorrichtung durch eine Nullpunktvorrichtung (21) ermittelt wird.

2. Meß- und Sortieranlage nach Anspruch 1, **dadurch gekennzeichnet, daß** die Transportvorrichtung eine Scheibe (14, 43) umfaßt, in der stirnseitig Schlitze (15, 44) vorgesehen sind, in die die Widerstandskörper (2) über eine Zufuhrvorrichtung (13) zuführbar sind.

3. Meß- und Sortieranlage nach Anspruch 1, **dadurch gekennzeichnet, daß** die Scheibe (14, 43) zumindest teilweise in die Temperiervorrichtung (7, 48, 49) hinei nragt.

4. Meß- und Sortieranlage nach einem der Ansprüche 2 oder 3, **dadurch gekennzeichnet, daß** die Scheibe (14, 43) aus mehreren Einzelscheiben gebildet ist.

5. Meß- und Sortieranlage nach einem oder mehreren der vorhergehenden Ansprüche, **dadurch gekennzeichnet, daß** die Schlitze (15, 44) der Scheibe (14, 43) um 90° versetzte Öffnungen (16, 45) aufweisen, über die die Aufnahmevorrichtung (4, 46) mit dem Widerstandskörper (2) kontaktierbar sind.

6. Meß- und Sortieranlage nach einem oder mehreren der vorhergehenden Ansprüche, **dadurch gekennzeichnet, daß** die Temperiervorrichtung (7, 48, 49) eine zur Temperaturüberwachung angeordnete Regel- und/oder Steuervorrichtung (10) sowie zumindest einer Heizvorrichtung (11) zum Beheizen des Mediums (9) aufweist.

7. Meß- und Sortieranlage nach einem oder mehreren der vorhergehenden Ansprüche, **dadurch gekennzeichnet, daß** die Scheibe (14, 43) über einen Schrittmotor (19) angetrieben ist, und daß die Nullpunktvorrichtung (21) zur Positionsbestimmung der einzelnen in den Schlitzen (15, 44) befindlichen Widerstandskörpern (2) durch einen Nullpunktsensor (22) und einen Kontakt (23) gebildet ist.

8. Meß- und Sortieranlage nach einem oder mehreren der vorhergehenden Ansprüche, **dadurch gekennzeichnet, daß** mehrere parallel zueinander angeordnete Zufuhr- und Transportvorrichtungen (12, 42), insbesondere Scheiben (14, 43) angeordnet sind, wobei jeder Scheibe (14, 43) eine Aufnahmevorrichtung (4, 46) oder eine über Führungen verfahrbare Aufnahmevorrichtung (4, 46) zugeordnet ist.

9. Meß- und Sortieranlage nach einem oder mehreren der vorhergehenden Ansprüche, **dadurch gekennzeichnet, daß** die Zufuhr- und Transportvorrichtung (12, 42) durch ein Transportband (47), einen Transportgurt oder einen Plistergurt gebildet ist.

10. Meß- und Sortieranlage nach einem oder mehreren der vorhergehenden Ansprüche, **dadurch gekennzeichnet, daß** die Zufuhr- und Transportvorrichtung (12, 42) derart ausgebildet ist, daß durch die Zufuhr- und Transportvorrichtung (12, 42) mehrere nebeneinander angeordnete Temperiervorrichtungen (7, 48, 49) verbunden sind.

11. Meß- und Sortieranlage nach einem oder mehreren der vorhergehenden Ansprüche, **dadurch gekennzeichnet, daß** zumindest in jeder Temperiervorrichtung (7, 48, 49) eine Meßstation (3, 51, 52) angeordnet ist, wobei bei der ersten Meßstation (3, 51, 52) die Zufuhrvorrichtung (13) und bei der letzten Meßstation (3, 51, 52) die Ausgabevorrichtung (25) angeordnet ist.

12. Meß- und Sortieranlage nach einem oder mehreren der vorhergehenden Ansprüche, **dadurch gekennzeichnet, daß** die einzelnen Meßstationen (3, 51, 52) mit einer gemeinsamen oder mit mehreren Steuervorrichtungen (20) verbunden sind.

13. Meß- und Sortieranlage nach einem oder mehreren der vorhergehende Ansprüche, **dadurch gekennzeichnet, daß** im Bereich jeder Temperiervorrichtung (7, 48, 49) bzw, jeder Meßstation (3, 51, 52) eine Ausgabevorrichtung (25) angeordnet ist.

14. Meß- und Sortieranlage nach einem oder mehreren der vorhergehenden Ansprüche, **dadurch gekennzeichnet, daß** die Ausgabevorrichtung (25) durch eine Sortiervorrichtung (26) gebildet ist.

15. Meß- und Sortieranlage nach einem oder mehreren der vorhergehenden Ansprüche, **dadurch gekennzeichnet, daß** mehrere Ausgabevorrichtungen (25) angeordnet sind.

16. Meß- und Sortieranlage nach einem oder mehreren der vorhergehenden Ansprüche, **dadurch gekennzeichnet, daß** am Transportband (47) mehrere nebeneinander angeordnete Widerstandskörper (2) positioniert sind.

17. Meß- und Sortieranlage nach einem oder mehreren der vorhergehenden Ansprüche, **dadurch gekennzeichnet, daß** für jeden am Transportband (47) nebeneinander angeordneten Widerstandskörper (2) eine eigene Aufnahmevorrichtung (4, 46) angeordnet ist.

18. Meß- und Sortieranlage nach einem oder mehreren der vorhergehenden Ansprüche, **dadurch gekennzeichnet, daß** die Aufnahmevorrichtung (4, 46) derart ausgebildet ist, daß von einer Aufnahmevorrichtung (4, 46) mehrere Widerstandskörper (2) kontaktierbar sind.

19. Meß- und Sortieranlage nach einem oder mehreren der vorhergehenden Ansprüche, **dadurch gekennzeichnet, daß** die Aufnahmevorrichtung (4, 46) zumindest zwei Kontaktstifte (17) aufweist.

20. Verfahren zum Messen und Klassifizieren von Widerstandskörpern, bei dem in einer Meßstation der Widerstandswert des über eine Zufuhr- und Transportvorrichtung der Meßstation zugeführten Widerstandskörpers gemessen wird und der gemessene Widerstandswert einer Auswerteeinheit einer Steuervorrichtung übermittelt wird und der Widerstandskörper in einer der Meßstation nachgeordneten Ausgabevorrichtung nach vorgegebenen Meßbereichen sortiert abgegeben wird, **dadurch gekennzeichnet, daß** die Position des Widerstandskörpers auf der Zufuhr- und Transportvorrichtung über eine Nullpunktvorrichtung erfaßt und danach der Widerstandskörper in einem Medium auf eine vordefinierte Nenntemperatur über eine Temperiervorrichtung, aufgewärmt wird und nach dem Erreichen dieser Nenntemperatur der Widerstandskörper im Medium kontaktiert wird und daraufhin die Messung durchgeführt wird.

## Claims

1. Instrument for measuring and sorting resistors according to their resistance values, with a disc-shaped delivery and conveyor system for the resistors, a measuring station, an output device disposed downstream thereof and a heating device with a container filled with a liquid medium, **characterised in that** the measuring station (3, 51, 52) is disposed in the heating device (7, 48, 49) and the position of the resistors (2) on the delivery and conveyor system is determined by a zero adjusting device (21).

2. Measuring and sorting instrument as claimed in claim 1, **characterised in that** the conveyor system comprises a disc (14, 43) in which end face slits (15, 44) are provided, into which the resistors (2) can be fed via a delivery device (13).

3. Measuring and sorting instrument as claimed in claim 1, **characterised in that** the disc (14, 43) projects at least partially into the heating device (7, 48, 49).

4. Measuring and sorting instrument as claimed in one of claims 2 or 3, **characterised in that** the disc (14, 43) is made up of several individual discs.

5. Measuring and sorting instrument as claimed in one or more of the preceding claims, **characterised in that** the slits (15, 44) of the disc (14, 43) have openings (16, 45) disposed at an angle of 90°, by means of which the receiving device (4, 46) and the resistor (2) can be placed in contact.

6. Measuring and sorting instrument as claimed in one or more of the preceding claims, **characterised in that** the heating device (7, 48, 49) has a control and/or regulating device (10) for monitoring the temperature and at least one heating device (11) for heating the medium (9).

7. Measuring and sorting instrument as claimed in one or more of the preceding claims, **characterised in that** the disc (14, 43) is driven by a stepper motor (19) and the zero adjustment device (21) for determining the position of the individual resistors (2) disposed in the slits (15, 44) comprises a zero position sensor (22) and a contact (23).

8. Measuring and sorting instrument as claimed in one or more of the preceding claims, **characterised in that** several delivery and conveyor systems (12, 42) are arranged parallel with one another, in particular discs (14, 43), each disc (14, 43) co-operating with a receiving device (4, 46) or a receiving device (4, 46) which can be displaced by means of guides.

9. Measuring and sorting instrument as claimed in one or more of the preceding claims, **characterised in that** the delivery and conveyor system (12, 42) is provided in the form of a band conveyor (47), a belt conveyor or a blister belt.

10. Measuring and sorting instrument as claimed in one or more of the preceding claims, **characterised in that** the delivery and conveyor system (12, 42) is designed so that several heating devices (7, 48, 49) arranged adjacent to one another can be linked by the delivery and conveyor system (12, 42).

11. Measuring and sorting instrument as claimed in one or more of the preceding claims, **characterised in that** at a measuring station (3, 51, 52) is provided at least in every heating system (7, 48, 49), the delivery device (13) being disposed at the first measuring station (3, 51, 52) and the output device (25) being disposed at the last measuring station (3, 51, 52).

12. Measuring and sorting instrument as claimed in one or more of the preceding claims, **characterised in that** the individual measuring stations (3, 51, 52) are connected to a common or to several control device(s) (20).

13. Measuring and sorting instrument as claimed in one or more of the preceding claims, **characterised in that** an output device (25) is arranged in the region of every heating device (7, 48, 49) or every measuring station (3, 51, 52).

14. Measuring and sorting instrument as claimed in one or more of the preceding claims, **characterised in that** the output device (25) is provided in the form of a sorting device (26).

15. Measuring and sorting instrument as claimed in one or more of the preceding claims, **characterised in that** several output devices are provided (25).

16. Measuring and sorting instrument as claimed in one or more of the preceding claims, **characterised in that** several resistors (2) are positioned adjacent to one another on the belt conveyor (47).

17. Measuring and sorting instrument as claimed in one or more of the preceding claims, **characterised in that** a separate receiving device (4, 46) is provided for every adjacent resistor (2) disposed on the belt conveyor (47).

18. Measuring and sorting instrument as claimed in one or more of the preceding claims, **characterised in that** the receiving device (4, 46) is designed so that several resistors (2) can be placed in contact with one receiving device (4, 46).

19. Measuring and sorting instrument as claimed in one or more of the preceding claims, **characterised in that** the receiving device (4, 46) has at least two contact pins (17).

20. Method of measuring and sorting resistors, whereby the resistance value of the resistor delivered to a measuring station by a delivery and conveyor system is measured and the measured resistance value is transmitted to an evaluation unit of a control device and the resistor is discharged to an output unit downstream of the measuring station once the measurement ranges have been sorted, **characterised in that** the position of the resistor on the delivery and conveyor system is detected by a zero adjusting device, after which the resistor is heated to a predefined nominal temperature in a medium by a heating device and, once this nominal temperature is reached, a contact is made with the resistor in the medium and the measurement is taken.

## Revendications

1. Installation pour mesurer et classer des résistances en fonction de leurs valeurs de résistance, avec un dispositif d'amenée et de transport réalisé en forme de disque pour les résistances, un poste de mesure, un dispositif d'émission disposé en aval de celui-ci et un dispositif tempérant qui présente un bassin de réception rempli d'un milieu liquide, **caractérisée en ce que** le poste de mesure (3, 51, 52) est disposé dans le dispositif tempérant (7, 48, 49), et **en ce que** la position des corps de résistance (2) sur le dispositif d'amenée et de transport est déterminée par un dispositif du zéro (21).

2. Installation pour mesurer et classer selon la revendication 1, **caractérisée en ce que** le dispositif de transport comprend un disque (14, 43) dans lequel sont prévues, côté frontal, des fentes (15, 44) dans lesquelles les résistances (2) peuvent être amenées par un dispositif d'amenée (13).

3. Installation pour mesurer et classer selon la revendication 1, **caractérisée en ce que** le disque (14, 43) fait saillie au moins partiellement dans le dispositif tempérant (7, 48, 49).

4. Installation pour mesurer et classer selon l'une des revendications 2 ou 3, **caractérisée en ce que** le disque (14, 43) est constitué de plusieurs disques individuels.

5. Installation pour mesurer et classer selon l'une ou plusieurs des revendications précédentes, **caractérisée en ce que** les fentes (15, 44) du disque (14, 43) présentent des ouvertures (16, 45) décalées de 90° par lesquelles le dispositif de réception (4, 46) peut être mis en contact avec la résistance (2).

6. Installation pour mesurer et classer selon l'une ou plusieurs des revendications précédentes, **caractérisée en ce que** le dispositif tempérant (7, 48, 49) présente un dispositif de réglage et/ou de commande (10) disposé pour la surveillance de la température ainsi qu'au moins un dispositif de chauffage (11) pour chauffer le milieu (9).

7. Installation pour mesurer et classer selon l'une ou plusieurs des revendications précédentes, **caractérisée en ce que** le disque (14, 43) est entraîné par un moteur pas-à-pas (19), et **en ce que** le dispositif du zéro (21) est réalisé pour la détermination de la position des résistances individuelles (2) se trouvant dans les fentes (15, 44) par un capteur du zéro (22) et un contact (23).

8. Installation pour mesurer et classer selon l'une ou plusieurs des revendications précédentes, **caractérisée en ce que** sont disposés plusieurs dispositifs d'amenée et de transport (12, 42), notamment des disques (14, 43) disposés parallèlement les uns aux autres, où est associé à chaque disque (14, 43) un dispositif de réception (4, 46) ou un dispositif de réception (4, 46) déplaçable par des guidages.

9. Installation pour mesurer et classer selon l'une ou plusieurs des revendications précédentes, **caractérisée en ce que** le dispositif d'amenée et de transport (12, 42) est formé par une bande de transport (47), une courroie de transport ou une courroie de "blister".

10. Installation pour mesurer et classer selon l'une ou plusieurs des revendications précédentes, **caractérisée en ce que** le dispositif d'amenée et de transport (12, 42) est réalisé de façon que par le dispositif d'amenée et de transport (12, 42), plusieurs dispositifs tempérants (7, 48, 49) disposés les uns à côté des autres soient reliés.

11. Installation pour mesurer et classer selon l'une ou plusieurs des revendications précédentes, **caractérisée en ce qu'**il est disposé au moins dans chaque dispositif tempérant (7, 48, 49) un poste de mesure (3, 51, 52), où est disposé auprès du premier poste de mesure (3, 51, 52) le dispositif d'amenée (13) et auprès du dernier poste de mesure (3, 51, 52) le dispositif d'émission (25).

12. Installation pour mesurer et classer selon l'une ou plusieurs des revendications précédentes, **caractérisée en ce que** les postes de mesure individuels (3, 51, 52) sont reliés à un dispositif de commande commun ou à plusieurs dispositifs de commande (20).

13. Installation pour mesurer et classer selon l'une ou plusieurs des revendications précédentes, **caractérisée en ce qu'**un dispositif d'émission (25) est disposé au voisinage de chaque dispositif tempérant (7, 48, 49) respectivement de chaque poste de mesure (3, 51, 52).

14. Installation pour mesurer et classer selon l'une ou plusieurs des revendications précédentes, **caractérisée en ce que** le dispositif d'émission (25) est formé par un dispositif de classement (26).

15. Installation pour mesurer et classer selon l'une ou plusieurs des revendications précédentes, **caractérisée en ce que** sont disposés plusieurs dispositifs d'émission (25).

16. Installation pour mesurer et classer selon l'une ou plusieurs des revendications précédentes, **caractérisée en ce que** plusieurs résistances (2) disposées les unes à côté des autres sont positionnées à la bande de transport (47).

17. Installation pour mesurer et classer selon l'une ou plusieurs des revendications précédentes, **caractérisée en ce qu'**un dispositif de réception propre (4, 46) est disposé pour chacun des corps de résistance (2) disposés à la bande de transport (47) les uns à côté des autres.

18. Installation pour mesurer et classer selon l'une ou plusieurs des revendications précédentes, **caractérisée en ce que** le dispositif de réception (4, 46) est réalisé de façon que par un dispositif de réception (4, 46), plusieurs résistances (2) peuvent être contactées.

19. Installation pour mesurer et classer selon l'une ou plusieurs des revendications précédentes, **caractérisée en ce que** le dispositif de réception (4, 46) présente au moins deux broches de contact (17).

20. Procédé pour mesurer et classer des résistances, où est mesurée dans un poste de mesure la valeur de résistance de la résistance amenée au poste de mesure par un dispositif d'amenée et de transport, et la valeur de résistance mesurée est transmise à une unité d'évaluation d'un dispositif de commande, et la résistance est remise dans un dispositif d'émission disposé en aval du poste de mesure en étant classée selon des zones de mesure prédéterminées, **caractérisé en ce que** la position de la résistance sur le dispositif d'amenée et de transport est détectée par un dispositif du zéro et qu'ensuite la résistance est chauffée dans un milieu à une température nominale prédéfinie par un dispositif tempérant et, après l'atteinte de cette température nominale, la résistance est contactée dans le milieu et ensuite, la mesure est effectuée.
